Europäisches Patentamt

European Patent Office

Office européen des brevets

(11) Publication number: **0 061 387**
**A2**

# EUROPEAN PATENT APPLICATION

(21) Application number: **82400444.4**

(22) Date of filing: **12.03.82**

(51) Int. Cl.³: **H 01 L 27/04**
**H 01 L 21/82**

(30) Priority: **16.03.81 US 244440**

(43) Date of publication of application:
**29.09.82 Bulletin 82/39**

(84) Designated Contracting States:
**DE FR GB IT NL**

(71) Applicant: **FAIRCHILD CAMERA & INSTRUMENT**
**CORPORATION**
**464 Ellis Street**
**Mountain View California 94042(US)**

(72) Inventor: **Vora, Madhukar B.**
**110 Lansberry Court**
**Los Gatos California 95030(US)**

(74) Representative: **Chareyron, Lucien et al,**
**Schlumberger Limited 42, rue Saint-Dominique**
**F-75340 Paris Cedex 07(FR)**

(54) Logic gate structure using space charge limited transistors.

(57) An intregrated circuit structure is disclosed in which a
pair of complementary lateral space charge limited transis-
tors are formed together with at least one Schottky diode to
create a logic gate. The structure includes a semiconductor
substrate, a first and a second region of N conductivity type
spaced apart in the substrate, a third and a fourth region of P
conductivity type, the third region separating the first region
from the second region, and the second region separating
the third region from the fourth region. The first region has a
graduated impurity concentration which is less than $10^{18}$
atoms per cubic centimeter at the surface and at least $10^{18}$
atoms per cubic centimeter at a selected depth below the
surface of the substrate.

FIG 4

1

# LOGIC GATE STRUCTURE USING SPACE
# CHARGE LIMITED TRANSISTORS

## BACKGROUND OF THE INVENTION

### Field of the Invention

This invention relates to integrated circuit structures, and in particular to an integrated circuit structure including a complementary lateral transistor pair of space charge limited transistors forming a logic gate.

### Description of the Prior Art

The space charge limited transistor was originally proposed by William Shockley and R.C. Prim in "Space Charge Limited Emission in Semiconductors", Physics Review 90, pp. 753-8 (1953). The theory and operation of such devices has been the subject of several technical papers. See, for example, "Theory and Operation of Space-Charge-Limited Transistors With Transverse Injection" by S. Magdo, IBM Journal of Research and Development, September, 1973, pp. 443-58.

According to Magdo, the current in such transistors is controlled by varying the electric field in a high resistivity base region with a control electrode and by injection of carriers of conductivity type opposite to those which carry the current. Magdo also reports that NPN and PNP transistors utilizing this principle have been found to have reasonable current gains. Unfortunately the output conductance and effective gain of a space charge limited transistor is determined by the width of the base region, which in turn has been limited by the photolithographic capabilities of integrated circuit manufacturers. With the advent of electron beam mask making, however, very fine line widths, on the order of less than 1 micron, are possible. Thus the performance of space charge limited transistors may be made compatible to bipolar or field effect transistors.

## SUMMARY OF THE INVENTION

A general object of this invention is to provide an integrated circuit logic gate which utilizes a complementary pair of space charge limited transistors.

This and other objects of the invention are attained, in accordance with one aspect of the invention by an integrated circuit structure comprising a semiconductor substrate; a first region and a second region of first conductivity type spaced apart in the substrate adjacent the surface of the substrate; a third region and a fourth region, both of opposite conductivity type to the first conductivity type, the third region separating the first region from the second region and the second region separating the third region from the fourth region; and the first and second regions having a graduated doping concentration which is less than $10^{18}$ atoms per cubic centimeter at the surface of the substrate and at least $10^{18}$ atoms per cubic centimeter at a selected depth below the surface of the substrate.

Another aspect of the invention includes a method for producing an integrated circuit structure including a complementary space charge limited lateral transistor pair, the method comprising the steps of: forming a first

0061387

- 3 -

region of first conductivity type in a substrate adjacent the surface of said substrate, said first region having a graduated impurity concentration which is less than $10^{18}$ atoms per cubic centimeter at the surface of said substrate and at least $10^{18}$ atoms per cubic centimeter at a selected depth below the surface of said substrate; forming a second region of said first conductivity type on said substrate, spaced apart from said first region; forming a third and a fourth region, each of opposite conductivity type to said first conductivity type, on said substrate, said third region separating said first region from said second region and said second region separating said third region from said fourth region.

### BRIEF DESCRIPTION OF THE DRAWINGS

Fig. 1 is a cross-sectional view of a semiconductor structure after formation of a first N conductivity type region and a region of insulating material.

Fig. 2 is a subsequent cross-sectional view after introduction of P type impurities.

Fig. 3 is a subsequent cross-sectional view following introduction of additional N type impurities.

Fig. 4 is a subsequent cross-sectional view showing the appearance of the structure after formation of ohmic connections and Schottky diodes.

Fig. 5 is a top view of the structure shown in Fig. 4.

Fig. 6 shows a typical doping gradient for the first N type region.

Fig. 7 is a circuit schematic illustrating interconnecting several of the structures depicted in Figs. 4 and 5.

### DESCRIPTION OF THE PREFERRED EMBODIMENTS

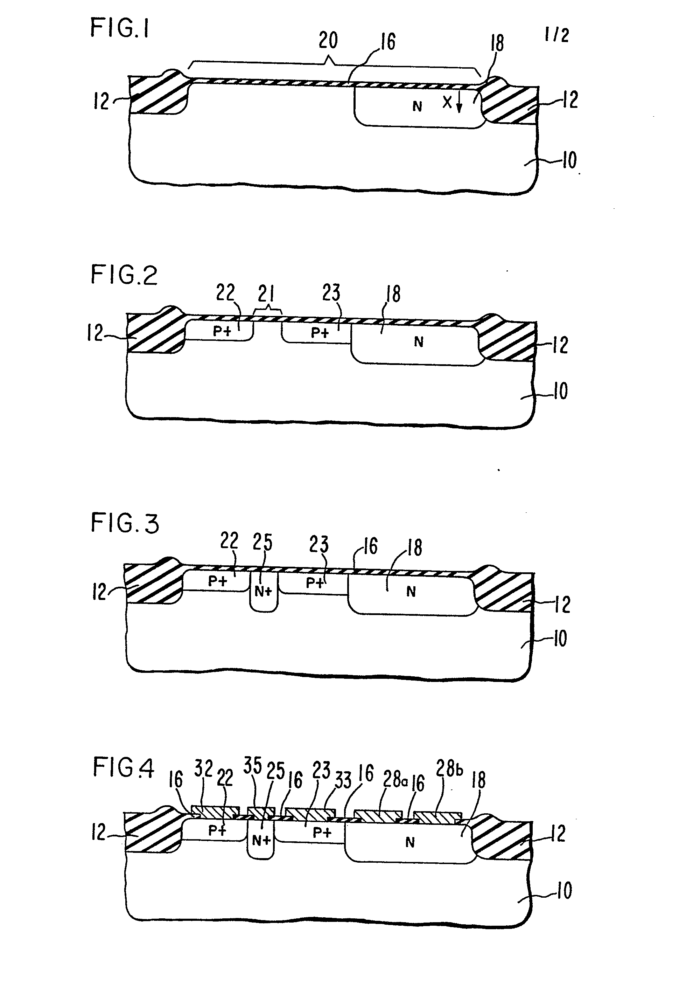

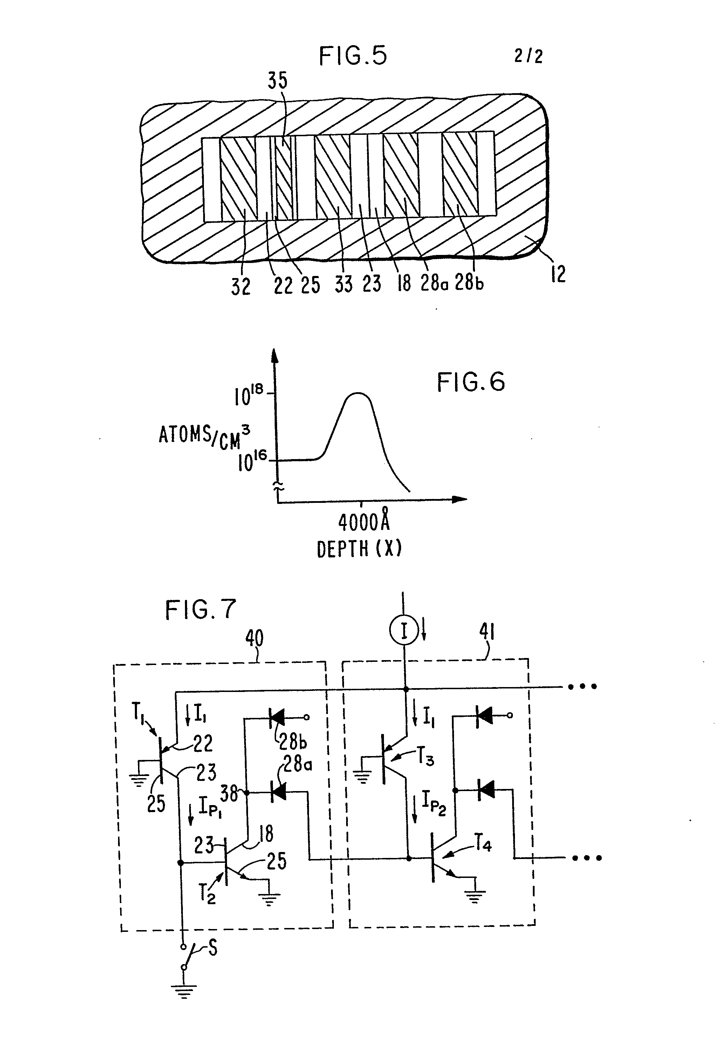

Figs. 1-4 depict one process for manufacturing a preferred embodiment of the invention shown in cross section in Fig. 4. The structure shown in Fig. 1 may be achieved using known integrated circuit fabrication technology. For example, a semiconductor substrate 10 is fabricated from intrinsic monocrystalline silicon of greater than 2000 ohm-cm resistivity. Such substrate material may be purchased commercially. A layer of silicon dioxide 16 is formed across the surface of substrate 10, for example, to a thickness of 1000 angstroms, by heating the substrate 10 in oxygen to 1000°C for one-half hour. Using known fabrication techniques, a channel is etched in the substrate 10 and oxidized to create an annular band of silicon dioxide 12 which surrounds a region 20 of substrate 10. One process for fabricating this structure is described in more detail in U.S. Patent No. 3,648,125 issued to Douglas Peltzer.

Using known ion implantation and photolithographic technology, an N conductivity type region 18 is created in substrate 10 over a portion of region 20. Phosphorous dopant may be used to create N type region 18. The doping profile of the implantation, that is, the variation of impurity concentration as a function of depth X (in Fig. 1), is shown in Fig. 6. At the surface of region 18 immediately beneath oxide layer 16, the impurity concentration is less than $10^{18}$ atoms of phosphorous per cubic centimeter. In the preferred embodiment the concentration is $10^{16}$ atoms of phosphorous per cubic centimeter. An impurity concentration less than $10^{18}$ atoms per cubic centimeter is necessary for the subsequent formation of Schottky diodes on the surface of region 18. At a depth further beneath the surface of region 18, the doping concentration increases to approximately $10^{18}$ atoms per cubic centimeter. In the preferred embodiment this concentration is achieved 4000 angstroms below the surface. The higher doping concentration beneath the surface is necessary to reduce the resistivity of what will be the NPN transistor collector which is in series with the Schottky diodes. An impurity concentration gradient such as depicted in Fig. 6 may be achieved using known ion implantation apparatus, an implant energy of about 300 kev, and a dose of $10^{14}$ atoms per square centimeter.

As then shown in Fig. 2, P+ conductivity type regions 22 and 23 are formed in substrate 10 using, for example, known self-aligned photolithographic integrated circuit fabrication techniques. Region 23 is positioned to be adjacent region 18, and a portion 21 of the semiconductor substrate 10 between regions 22 and 23 is not doped. Regions 22 and 23 may be fabricated using known ion implantation techniques, and in the preferred embodiment a substantially uniform impurity concentration of $10^{19}$ atoms per cubic centimeter of boron is introduced throughout regions 22 and 23.

An N conductivity type region 25 is then formed between P regions 22 and 23. Region 25 is also formed using known integrated circuit fabrication techniques, for example ion implantation. In the preferred embodiment region 25 will have a substantially uniform impurity concentration of $10^{20}$ atoms per cubic centimeter of phosphorous or arsenic.

As shown in Fig. 4, openings are then made in silicon dioxide layer 16 using known photolithographic or other techniques to permit electrical connections to the underlying regions, for example, regions 18, 22, 23 and 25. In one embodiment this is accomplished using a layer of aluminum which is subsequently patterned using known techniques to create connections 32, 33, and 35, to regions 22, 23, and 25, respectively. Portions of aluminum 28a and 28b will form Schottky diodes when deposited atop region 18. The lateral NPN transistor is formed by N region emitter 25, P region base 23, and N region collector 18, while the lateral PNP transistor is formed by P region emitter 22, N region base 25 and P region collector 23. The theory and operation of the resulting space charge limited transistors is explained in the article by S. Magdo discussed above.

Fig. 5 is a top view of the structure shown in Fig. 4 except with oxide layer 16 removed to show the underlying regions. Fig. 5 shows that silicon dioxide 12 surrounds the logic gate structure to electrically isolate it from other structures formed in the same substrate 10. The compact rectangular arrangement of the complementary lateral transistors is also depicted. Connections to the NPN transistor are formed by contacts 35, 33 and 28, while to PNP transitor is connected by contacts 32, 35 and 33. The structure shown in Figs. 4 and 5 provides several advantages over prior art structures. The structure is simple to fabricate using known technology and only three implantations of impurities. The performance of the resulting logic gate is comparable to logic gates fabricated with bipolar technology, and the structure has substantially the same temperature characterization as bipolar devices. Using 0.5 micron wide metal connecting lines, the overall logic gate structure shown in Fig. 5 will be approximately 2.5 microns by 9 microns.

Fig. 7 is a circuit schematic showing a series of cells 40, 41, etc., each one of which is fabricated using the structure depicted in Figs. 4 and 5. In cell 40 the portions of the complementary PNP and NPN transistors, and the Schottky diodes, are given designations to correspond to those shown in Figs. 4 and 5.

The logic gate structure shown in Fig. 7 operates in the following manner. If switch S is open, current $I_1$, known as the injector current, will cause a corresponding current $I_{P_1}$ to flow in the collector 23 of the PNP transistor $T_1$. Current $I_{P_1}$ will force transistor $T_2$ on, which in turn causes the potential at node 38 to be nearly zero. This low potential, in turn, causes current $I_{P_2}$ to flow through diode 28a and transistor $T_2$ because the potential difference across transistor $T_2$ and diode 28a will be less than the base-emitter voltage ($V_{BE}$) of transistor $T_4$. With the potential across $T_4$ being less than the drop across diode 28a, transistor $T_4$ will not turn on and a current $I_{P_3}$ will flow in the next cell. This sequence will continue for all subsequent cells.

On the other hand if switch S is closed, current $I_{P_1}$ will flow through switch S to ground keeping transistor $T_2$ off. Current $I_{P_2}$ will force transistor $T_4$ on causing the next transistor in the sequence to be off. Thus when switch S is open transistors $T_1$, $T_3$, etc. will be on and transistors $T_2$, $T_4$, etc. will be off. Opposite states will occur when switch S is closed.

Although the integrated circuit structure of this invention has been described in conjunction with reference to a preferred embodiment, the description is intended to be illustrative of the invention and not to be construed as limiting it. Various modifications and applications may occur to those skilled in the art without departing from the scope of the invention as defined by the appended claims. For example, the conductivity types of the regions depicted and discussed may be reversed.

WHAT IS CLAIMED IS:

1. An integrated circuit structure including a complementary space charge limited lateral transistor pair characterized by:

a semiconductor substrate having a surface;

a first region and a second region of first conductivity type space apart in the substrate adjacent the surface of the substrate; and

a third region and a fourth region, each of opposite conductivity type to the first conductivity type, the third region separating the first region from the second region, and the second region separating the third region from the fourth region, the first region having a graduated impurity concentration which is less than $10^{18}$ atoms per cubic centimeter at the surface of the substrate and at least $10^{18}$ atoms per cubic centimeter at a selected depth below the surface of the substrate.

2. Structure as in claim 1 characterized in that the third region is a base of a first transistor and a collector of a second transistor.

3. Structure as in claim 1 or 2 characterized in that the second region is an emitter of the first transistor and a base of the second transistor.

4. Structure as in claim 1, 2 or 3 characterized in that the first region is a collector of the first transistor.

5. Structure as in any one of claims 1-4 characterized in that the fourth region is an emitter of the second transistor.

6. Structure as in any one of claims 1-5 characterized in that each of the first region and the second region extend deeper into the substrate than either of the third region and the fourth region.

7. Structure as in any previous claim characterized in that at least one Schottky diode is formed on the surface of the first region.

8. Structure as in claim 7 characterized in that two Schottky diodes are formed on the surface of the first region.

9. Structure as in any previous claim characterized in that all of the first, second, third and fourth regions are surrounded by a region of oxidized semiconductor material.

10. Structure as in claim 9 characterized in that the oxidized semiconductor material comprises silicon dioxide.

11. Structure as in any previous claim characterized in that the first region and the second region are N conductivity type.

12. Structure as in any previous claim characterized in that the first region and the second

0061387

-10-

region are P conductivity type.

13. A method for producing an integrated circuit structure including a complementary space charge limited lateral transistor pair, the method being characterized by the steps of:

forming a first region of first conductivity type in a substrate adjacent the surface of said substrate, said first region having a graduated impurity concentration which is less than $10^{18}$ atoms per cubic centimeter at the surface of said substrate and at least $10^{18}$ atoms per cubic centimeter at a selected depth below the surface of said substrate;

forming a second region of said first conductivity type on said substrate, spaced apart from said first region;

forming a third and a fourth region, each of opposite conductivity type to said first conductivity type, on said substrate, said third region separating said first region from said second region and said second region separating said third region from said fourth region.

FIG.1

FIG.2

FIG.3

FIG.4

FIG.5

FIG.6

FIG.7